# EUROPEAN PATENT SPECIFICATION

(11) **EP 2 346 100 B1**
(45) Date of publication and mention of the grant of the patent: **22.05.2019**
(21) Application number: 11150403.1
(22) Date of filing: 07.01.2011
(51) Int. Cl.: H01L 33/48, H01L 33/64, H05K 1/02, H05K 1/18, F21K 99/00, H01L 25/16, H01L 33/62, H01L 33/60

(54) **Light emitting apparatus and lighting system**
Lichtemittierende Vorrichtung und Beleuchtungssystem
Dispositif luminescent et système d'éclairage

(30) Priority: 15.01.2010 KR 20100004107; 01.04.2010 KR 20100030016
(43) Date of publication of application: 20.07.2011
(73) Proprietor: LG Innotek Co., Ltd., Seoul, 04637 (KR)
(72) Inventor: Min, Bong Kul, 100-714, Seoul (KR); Kim, Deung Kwan, 100-714, Seoul (KR)
(74) Representative: Cabinet Plasseraud

(56) References cited:
- JP-A- 2008 282 932
- US-A1- 2004 095 782
- US-A1- 2008 019 103
- US-B1- 6 428 189

## Description

### BACKGROUND

The embodiment relates to a light emitting device package, a light emitting apparatus, and a lighting system.

A light emitting diode (LED) is a semiconductor light emitting device that converts current into light.

A wavelength of light emitted from the LED may vary depending on a semiconductor material used for manufacturing the LED. This is because the wavelength of the emitted light varies depending on the bandgap of the semiconductor material, that is, the energy difference between valance band electrons and conduction band electrons.

Recently, the LED can generate light having high brightness, so that the LED has been expensively used as a light source for a display device, a vehicle, or a lighting device. In addition, the LED can represent a white color having superior light efficiency by employing fluorescence materials or combining LEDs having various colors. Document JP 2008-282932 discloses a LED device comprising lead frames, wherein the middle section of the lead frame on which the LED chips is mounted contacts a head dissipation surface which is accessible trough an opening in the PCB on which the LED device is mounted.

### SUMMARY

The embodiment provides a light emitting apparatus comprising a light emitting diode device package according to claim 1 and a light emitting module having a plurality of light emitting diode device packages according to claim 10.

The light emitting apparatus according to the invention is capable of effectively dissipating heat emitted from a light emitting device.

### BRIEF DESCRIPTION OF THE DRAWINGS

FIG. 1 is a perspective view showing a light emitting device package according to the embodiment forming part of the invention.
FIG. 2 is a sectional view showing a light emitting device package according to the embodiment forming part of the invention;
FIGS. 3 and 4 are views showing a light emitting apparatus according to the embodiment forming part of the invention;
FIG. 5 is a view showing a frame body used to manufacture frames of a light emitting device package according to the embodiment forming part of the invention;
FIG. 6 is a side sectional view showing a light emitting module and a light unit using the same according to another embodiment forming part of the invention;
FIG. 7 is an exploded perspective view showing a light unit of FIG. 6;
FIG. 8 is a perspective view showing a light unit of FIG. 6;
FIG. 9 is a perspective view showing an edge-type light unit;
FIG. 10 is a perspective view showing a direct-type light unit;
FIG. 11 is a view showing a light emitting module and a light unit using the same according to another embodiment forming part of the invention;
FIG. 12 is a view showing a light emitting module and a light unit using the same according to another embodiment not forming part of the invention;
FIG. 13 is a view showing a display apparatus according to the embodiment forming part of the invention;
FIG. 14 is a view showing another example of the display apparatus according to the embodiment; and
FIG. 15 is a view showing a light unit according to another embodiment forming part of the invention.

### DETAILED DESCRIPTION OF THE EMBODIMENTS

In the description of the embodiments, it will be understood that, when a layer (or film), a region, a pattern, or a structure is referred to as being "on" or "under" another board, another layer (or film), another region, another pad, or another pattern, it can be "directly" or "indirectly" over the other board, layer (or film), region, pad, or pattern, or one or more intervening layers may also be present. Such a position of the layer has been described with reference to the drawings.

The thickness and size of each layer shown in the drawings may be exaggerated, omitted or schematically drawn for the purpose of convenience or clarity. In addition, the size of elements does not utterly reflect an actual size.

Hereinafter, the embodiment will be described with respect to accompanying drawings.

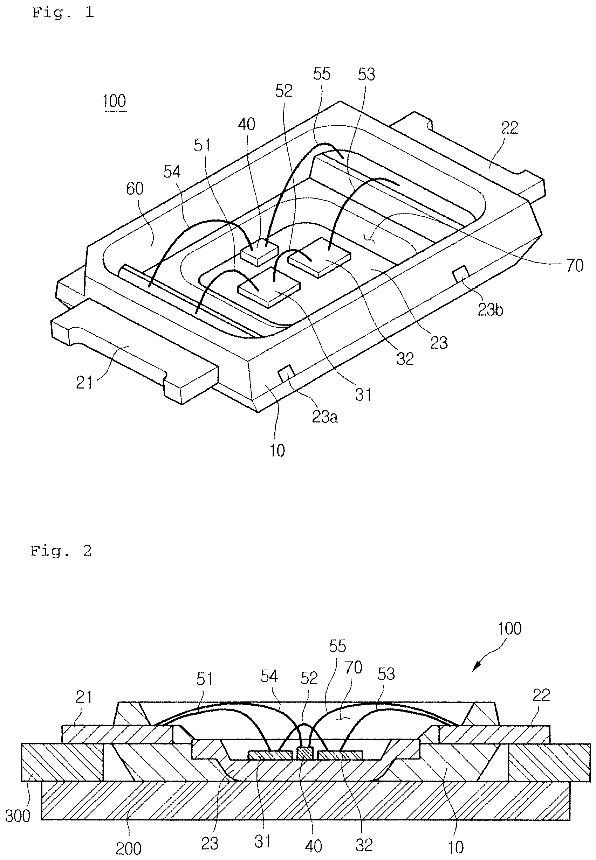

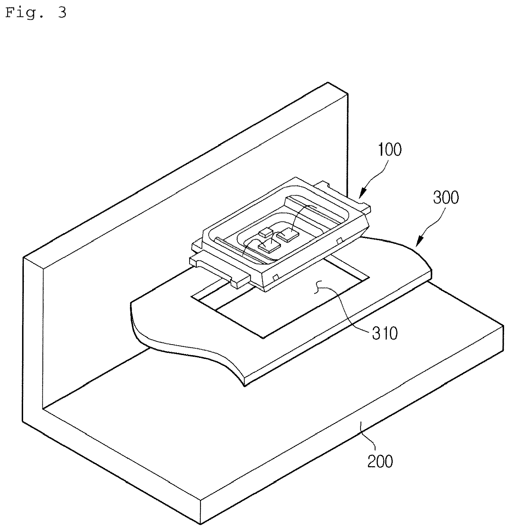

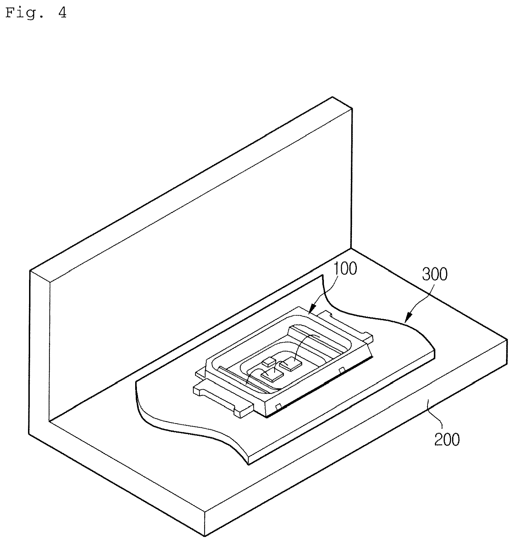

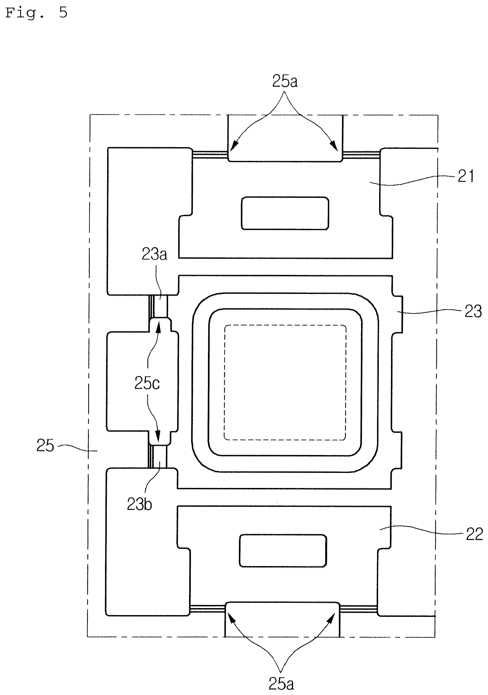

FIG. 1 is a perspective view showing a light emitting device package 100 according to the embodiment, and FIG. 2 is a sectional view showing the light emitting device package 100 according to the embodiment. FIGS. 3 and 4 are view showing a light emitting apparatus according to the embodiment, and FIG. 5 is a view showing frame bodies used to manufacture frames of the light emitting device package 100 according to the embodiment.

Referring to FIGS. 1 and 2, the light emitting device package 100 according to the embodiment comprises a package body 10, first to third frames 21 to 23 formed in the package body 10, first and second light emitting devices 31 and 32 provided on the third frame 23, and an encapsulant layer 60 filled in a cavity 70 formed in the package body 10.

The package body 10 supports the first to third frames 21 to 23, provides a space in which the light emitting devices 31 and 32 are provided, and provides the cavity 70 in which the encapsulant layer 60 is filled. The package body 10 may comprise resin material, and may be injection molded together with the first to third frames 21 to 23.

The first and second frames 21 and 22 serve as lead frames to supply power to the first and second light emitting devices 31 and 32. The third frame 23 serves as a heat sink to effectively dissipate heat emitted from the light emitting devices 31 and 32 while serving as a reflective layer to effectively reflect light generated from the light emitting devices 31 and 32. The first to third frames 21 to 23 may comprise metallic material.

The first and second frames 21 and 22 pass through the package body 10 from both sides of the package body 10. In other words, parts of the first and second frames 21 and 22 are exposed in the cavity 70 of the body 10, and parts of the first and second frames 21 and 22 are exposed to the outside of the package body 10.

The third frame 23 is interposed between the first and second frames 21 and 22, and provided lower than the first and second frames 21 and 22. The third frame 23 is electrically insulated from the first and second frames 21 and 22.

A top surface of the third frame 23 forms a bottom surface of the cavity 70, and a bottom surface of the third frame 23 is aligned in line with a bottom surface of the package body 10.

The top surface of the third frame 23 comprises a first plane having a first height, a second plan having a second height lower than the first height, and an inclined surface connecting the first plane with the second plane. The second plane is provided thereon with the light emitting devices 31 and 32. According to the embodiment, although the two light emitting devices 31 and 32 are provided on the second plane, only one light emitting device or at least three light emitting devices are provided on the second plane. The first and second light emitting devices 31 and 32 may comprise a light emitting diode LED as one example.

In addition, a zener diode 40 may be provided on the second plane of the third frame 23. The zener diode 40 may protect the first and second light emitting devices 31 and 32 from ESD (Electro Static Discharge).

The first light emitting device 31, the second light emitting device 32, and the zener diode 40 may be electrically connected with the first and second frames 21 and 22 through wires.

A first wire 51 may electrically connect the first frame 21 with a first electrode layer of the first light emitting device 31. A second wire 52 may electrically connect a second electrode layer of the first light emitting device 31 with a first electrode layer of the second light emitting device 31. A third wire 53 may electrically connect the second electrode layer of the second light emitting device 32 with the second frame 22.

In addition, a fourth wire 54 electrically connects the first frame 21 with a first electrode layer of the zener diode 40, and a fifth wire 55 electrically connects a second electrode layer of the zener diode 40 with the second frame 22.

The encapsulant layer 60 including a transparent resin member, such as silicon resin or epoxy resin, is filled in the cavity 70 of the package body 10, and may contain fluorescence material. The fluorescence material may be uniformly distributed in the encapsulant layer 60 or may be provided at regions adjacent to the light emitting devices 31 and 32. The encapsulant layer 60 may comprise a transparent resin member and a fluorescence layer at a layer having various structures or various shapes.

Third frame connection parts 23a and 23b are exposed at lateral surfaces of the package body 10. The third frame connection parts 23a and 23b support the third frame 23 when the package body 10 is injection molded. Accordingly, after the injection molding has been completed, the third frame connection parts 23a and 23b are separated from the package body 10.

As shown in FIG. 5, the first to third frames 21 to 23 are coupled with the package body 10 through the injection molding process in a state in which the first to third frames 21 to 23 are supported with respect to a frame body 25. In addition, first to third cutting parts 25a, 25b, and 25c are cut so that the first to third frames 21 to 23 are separated from the frame body 25. In other words, the first to third frames 21 to 23 comprise same metal.

Since the third frame 23 is electrically and physically separated from the first and second frames 21 and 22, the third frame 23 is supported with respect to the frame body 25 by the third frame connection parts 23a and 23b. In addition, the third cutting part 25c is cut, so that third frame connection parts 23a and 23b are exposed at the lateral surfaces of the package body 10. According to the embodiment, although two third frame connection parts 23a and 23b are provided, more than the two third frame connection parts 23a and 23b may be used. In addition, one third frame connection part may be used.

Referring to FIGS. 2 to 4, the light emitting device package 100 is inserted into an opening 310 formed in a printed circuit board 300 and supported by a lower cover 200. The lower cover 200 may comprise metallic material having superior thermal conductivity.

The printed circuit board 300 is provided on the lower cover 200, and provided therein with the opening 310 so that a part of the lower cover 200 is exposed.

The light emitting device package 100 makes contact with the lower cover 200 through the opening 310. In other words, the package body 10 and the third frame 23 make contact with the lower cover 200.

In addition, the first and second frames 21 and 22 are electrically connected to a circuit pattern formed on a top surface of the printed circuit board 300. A thickness between the bottom surface of the package body 10 and the first and second frames 21 and 22 is the same to a thickness of the printed circuit board 300. Accordingly, the first and second frames 21 and 22 may make contact with the top surface of the printed circuit board 300, and the third frame 23 makes contact with the lower cover 200.

The light emitting apparatus is configured in such a manner that the printed circuit board 300 having the opening 310 is formed on the lower cover 200, and the light emitting device package 100 makes contact with the lower cover 200 through the opening 310. Since heat emitted from the light emitting device package 100 is directly transferred to the lower cover 200, the heat dissipation efficiency of the light emitting device package 100 can be improved.

Particularly, since the heat emitted from the first and second light emitting devices 31 and 32 are directly transferred to the third frame 23, and the heat transferred to the third frame 23 is directly transferred to the lower cover 200, thermal resistance is reduced, so that heat dissipation efficiency can be improved.

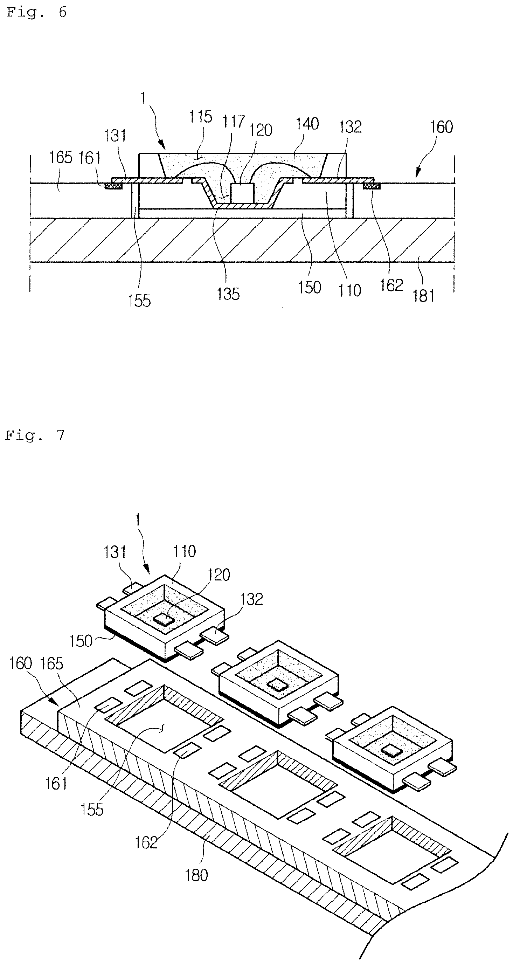

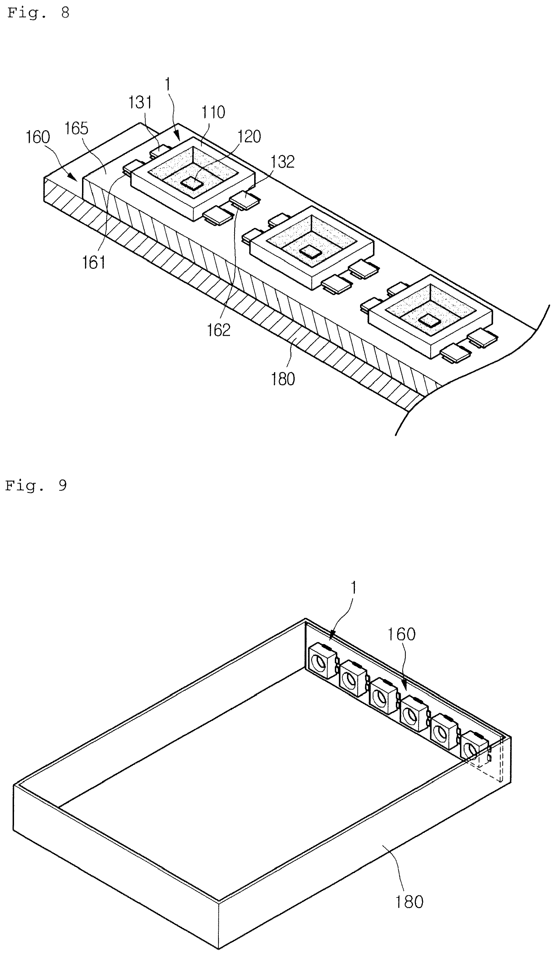

FIG. 6 is a sectional view showing a light emitting module and a light unit using the same according to another embodiment, and FIG. 7 is a perspective view showing the light unit of FIG. 6. FIG. 8 is a perspective view showing the light unit of FIG. 6.

Referring to FIGS. 6 and 8, the light emitting module according to the embodiment may comprise a plurality of light emitting devices packages 1, a board 160 including a plurality of openings 155 into which the light emitting devices packages 1 are inserted, and first and second circuit patterns 161 and 162 formed around the openings 155 of the board 160 and electrically connected to the light emitting device package 1.

The light unit according to the embodiment comprises the light emitting module and a support member 180 receiving the light emitting module.

The light emitting module according to the embodiment has a structure in which the light emitting device packages 1 are inserted into the openings 155, so that the light emitting device packages 1 may make contact with the support member 180. Therefore, since the heat generated from the light emitting device packages 1 can be directly dissipated to the support member 180, the heat dissipation efficiency of the light emitting module according to the embodiment can be improved.

Such improvement of the heat dissipation efficiency can minimize the damage and the discoloration of the light emitting device packages 1, so that the reliability for the light emitting module according to the embodiment can be improved.

Hereinafter, the light emitting module and the light unit using the same according to the embodiment will be described in detail while focusing on components of the light emitting module and the light unit.

The light emitting deice package 1 comprises a body 110, a first electrode 131, a second electrode 132, and a thermal conductive member 135 provided in the body 110, a light emitting device 120 provided on the thermal conductive member 135 and electrically connected with the first and second electrodes 131 and 132, a molding member 140 sealing the light emitting device 120, and a heat radiation pad 150 provided under the body 110 and the thermal conductive member 135.

The body 110 may comprise at least one selected from the group consisting of resin material such as PPA (Polyphthalamide), Si (silicon), aluminum (Al), aluminum nitride (AlN), AlOx, PSG (Photo Sensitive Glass), polyamide 9T (PA9T), SPS (Syndiotactic Polystyrene), metallic material, sapphire (Al₂O₃), BeO (Beryllium Oxide), and PCB (Printed Circuit Board). The body 110 may be formed through an injection molding process and an etching process, but the embodiment is not limited thereto.

If the body 110 comprises material having electrical conductivity, an insulating layer is additionally formed on the surface of the body 110, so that the body 110 can be prevented from being electrically shorted with the first and second electrodes 131 and 132.

The top surface of the body 110 may have various shapes such as a rectangular shape, a polygonal shape, and a circular shape according to the use and the design of the light emitting device package 1.

The body 110 is provided at an upper portion thereof with the cavity 115 having the shape of a cup or a concave vessel. The cavity 115 may have an internal lateral surface perpendicular to the bottom surface of the body 110 or a lateral surface inclined with respect to the body 110. When viewed in a plan view, the cavity 15 may have a circular shape, a rectangular shape, a polygonal shape, or an oval shape.

The first and second electrodes 131 and 132 may be spaced apart from each other in the body 110 in such a manner that the first and second electrodes 131 and 132 are electrically insulated from each other. The first and second electrodes 131 and 132 are electrically connected to the light emitting device 120 to supply power to the light emitting device 120.

The first and second electrodes 131 and 132 may comprise material having electrical conductivity. For example, the first and second electrodes 131 and 132 may comprise at least one selected from the group consisting of titanium (Ti), copper (Cu), nickel (Ni), gold (Au), chrome (Cr), tantalum (Ta), platinum (Pt), tin (Sn), silver (Ag), phosphorus (P), aluminum (Al), indium (In), palladium (Pd), cobalt (Co), silicon (Si), germanium (Ge), hafnium (Hf), ruthenium (Ru), and iron (Fe), or the ally thereof. In addition, the first and second electrodes 131 and 132 may have a single layer structure or a multiple layer structure, but the embodiment is not limited thereto.

The first and second electrodes 131 and 132 may protrude out of the body 110 to be electrically connected to first and second circuit patterns 161 and 162 of the board 160, so that power can be supplied to the light emitting device 120.

In order to fix the first and second electrodes 131 and 132 to the first and second circuit patterns 161 and 162, a soldering process is performed with respect to the first and second electrodes 131 and 132, so that the light emitting device package 1 can be provided on the board 160.

The thermal conductive member 135 may be provided in the body 110, and may form a part of the bottom surface of the light emitting device package 1.

The thermal conductive member 135 may comprise material having high thermal conductivity. For example, the thermal conductive member 135 may comprise metallic material, material containing carbon, or various resin materials, but the embodiment is not limited thereto.

As shown in FIG. 6, the thermal conductive member 135 may be provided therein with a second cavity 117. In other words, the second cavity 117 may be cavityed from a bottom surface of the first cavity 115, so that the first and second cavities 115 and 117 may form a step structure.

The step structure provides superior air tightness thereby preventing moisture or containments from being infiltrated into the light emitting device package 1. Due to the step structure, the thermal conductive member 135 is exposed to the bottom surface of the light emitting device package 1, so that the heat dissipation efficiency of the light emitting device package 1 can be improved.

The light emitting device 120 may be provided on the thermal conductive member 135. For example, the light emitting device 120 may comprise at least one LED (Light Emitting Diode). The LED may comprise at least one selected from the group consisting of color LEDs emitting red, green, or blue light, white LED emitting white light, and a UV (Ultra Violet) LED emitting ultra violet ray, but the embodiment is not limited thereto.

Although the light emitting device 120 is electrically connected to the first and second electrodes 131 and 132 through a wire bonding scheme as shown in the drawing, the light emitting device 120 may be electrically connected to the first and second electrodes 131 and 132 through a flip chip bonding scheme and a die bonding scheme, but the embodiment is not limited thereto.

The molding member 140 may be formed in the body 110 to seal the light emitting device 120. In other words, the molding member 140 may be filled in the first and second cavities 115 and 117.

The molding member 140 may comprise transmissive silicon material or transmissive resin material. The molding member 140 may comprise fluorescence material. The fluorescence material may be pumped by first light to generate second light emitted from the light emitting device 120. For example, if the light emitting device 120 is a blue LED, and yellow fluorescence material is used, the yellow fluorescence material is pumped by blue light to emit yellow light. As the blue and yellow light are mixed with each other, the light emitting device package 1 may provide white light, but the embodiment is not limited thereto.

Meanwhile, a lens may be additionally formed on the molding member 140 to adjust the distribution of light emitted from the light emitting device package 1. In addition, a zener diode may be further provided in the body 110 of the light emitting device package 1 in order to improve withstanding voltage.

The heat radiation pad 150 may be provided under the body 110 and the thermal conductivity member 135. Since the heat radiation pad 150 makes contact with the support member 180, the heat radiation pad 150 can effectively transfer heat generated from the light emitting device package 1 to the support member 180.

For example, the heat radiation pad 150 comprises a heat sink tape such as a thermally conductive tape or a UV tape (a tape attached when a UV ray is irradiated) and may be simply attached to the body 110 and the thermal conductive member 135.

In addition, the heat radiation pad 150 may be deposited, plated or coated through a spray coating scheme with materials, such as a metallic material, a material containing carbon, or various resin materials, having high thermal conductivity.

The heat radiation pad 150 may have various thicknesses. Preferably, the heat radiation pad 150 may have a thickness in the range of about 0.01mm to about 1mm. Since the heat radiation pad 150 has a proper thickness, the heat from the heat radiation pad 150 to the support member 180 can be rapidly discharged.

In addition, preferably, the bottom surface of the heat radiation pad 150 is aligned with the bottom surface of the board 160, or the bottom surface of the heat radiation pad 150 protrudes out of the bottom surface of the board 160. Accordingly, the heat radiation pad 150 can easily bond the light emitting device package 1 to the support member 180.

The board 160 may comprise an insulating layer 165, the first and second circuit patterns 161 and 162 on the insulating layer 165, and a plurality of openings 155 formed in the insulating layer 165 and receiving light emitting device packages 1.

In addition, although not shown, the board 160 may be additionally provided thereon with a connector receiving power from an external power source.

The board 160 may comprise at least one selected from the group consisting of a PCB (Printed Circuit Board), a metal core PCB, and a flexible PCB, but the embodiment is not limited thereto.

The openings 155 may be formed through the top and bottom surfaces of the board 160 and may have widths corresponding to that of a plurality of light emitting device packages 1.

The first and second circuit patterns 161 and 162 may be formed around the openings 155 on the insulating layer 165.

The first and second circuit patterns 161 and 162 are electrically connected with the connector to supply power to the light emitting device package 1. In this case, the first and second circuit patterns 161 and 162 are bonded with the first and second electrodes 131 and 132 of the light emitting device 1 through a soldering scheme, so that the first and second circuit patterns 161 and 162 may be electrically connected with the first and second electrodes 131 and 132 of the light emitting device 1.

When the light emitting device package 1 is inserted into the opening 155, an upper portion of the light emitting device package 1 with respect to the first and second electrodes 131 and 132 exposed out of the light emitting device package 1 protrudes upward from the board 160, and a lower portion of the light emitting device package 1 with respect to the first and second electrodes 131 and 132 is inserted into the opening 155. At least a part of the body 110 of the light emitting device package 1 may be inserted into the opening 155. Such a structure may be modified according to the design of the light emitting module according to the embodiment, but the embodiment is not limited thereto.

Preferably, the support member 180 may comprise a material having high thermal conductivity, and may receive the light emitting module.

The type of the support member 180 may vary according to the use of the light unit. For example, if the light unit comprises a BLU (Backlight Unit) serving as a light source of a display apparatus, the support member 180 may comprise a cover bottom to receive the light emitting module. Since the cover bottom may have the shape of a box having an open upper portion, the cover bottom can receive the light emitting module.

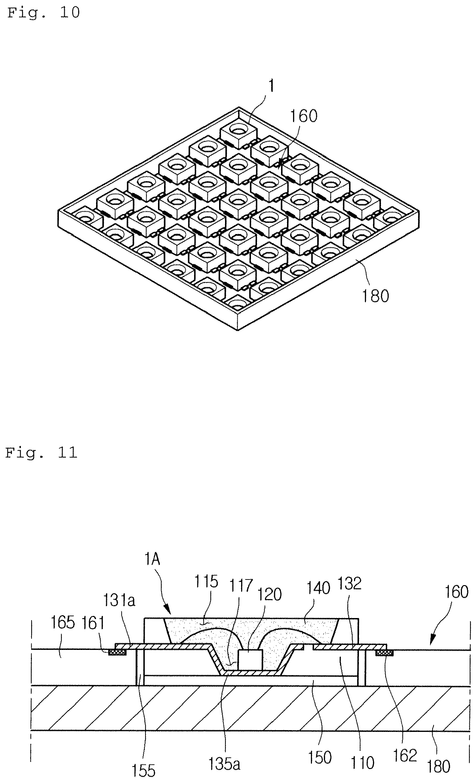

FIG. 9 is a perspective view showing an edge-type light unit, and FIG. 10 is a perspective view showing a direct-type light unit.

Referring to FIGS. 9 and 10, the BLU comprises a light guide member diffusing light to convert the light into surface light. Especially, the edge-type light unit of FIG. 9 irradiates light toward the lateral surface of the light guide member, and the direct-type light unit of FIG. 10 irradiates light upward under the light guide member.

In the case of the edge-type light unit of FIG. 9, the light emitting module may be provided on at least one internal lateral surface of the support member 180. In the case of the direct-type light unit of FIG. 10, the light emitting module may be provided on the bottom surface of the support member 180.

FIG. 11 is a view showing a light emitting module according to another embodiment and a light unit using the same.

Referring to FIG. 11, the light emitting module has the same structure as that of the light emitting module of FIG. 6 except for the structure of a light emitting device package 1A.

The emitting device package 1A comprises the body 110, a first electrode 131a and the second electrode 132 provided in the body 110, the light emitting device 120 provided on the first electrode 131a and electrically connected with the first and second electrodes 131a and the second electrode 132, the molding member 140 sealing the light emitting device 120, and the heat radiation pad 150 formed on bottom surfaces of the body 110 and the first electrode 131a.

The first electrode 131a may be provided therein with the second cavity 117, and the light emitting device 120 may be provided in the cavity 117.

Since the first electrode 131a has the second cavity 117, the first and second cavities 115 and 117 may have a step structure. Accordingly, the air tightness of the light emitting device package 1A can be improved.

In addition, since the first electrode 131a comprises the second cavity 117, a heat radiation part 135a provided under the first electrode 131a is bent so that the heat radiation part 135a can make contact with the heat radiation pad 150. In other words, the heat radiation part 135a of the first electrode 131a can make contact with the heat radiation pad 150 to perform a heat dissipation function.

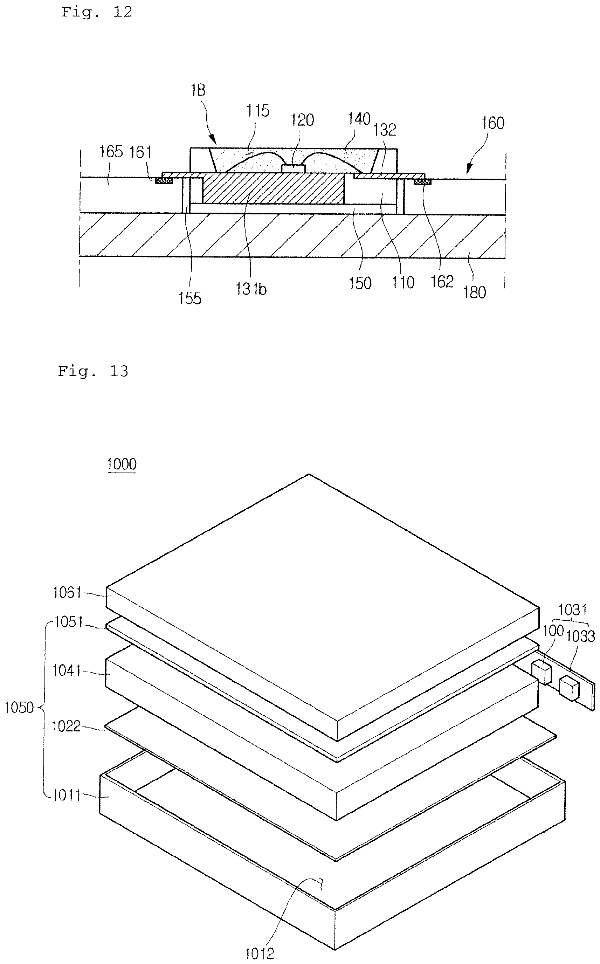

FIG. 12 is a view showing a light emitting module according to still another embodiment and a light unit using the same.

Referring to FIG. 12, the light emitting module has the same structure as that of the light emitting module of FIG. 11 except for the structure of a light emitting device package IB.

The emitting device package 1B comprises the body 110, a first electrode 131b and the second electrode 132 provided in the body 110, the light emitting device 120 provided on the first electrode 131b and electrically connected with the first and second electrodes 131b and the second electrode 132, the molding member 140 sealing the light emitting device 120, and the heat radiation pad 150 formed on bottom surfaces of the body 110 and the first electrode 131b.

Although a cavity is not formed in the first electrode 131b of the light emitting device package IB, a bottom surface of the first electrode 131b protrudes downward so that the first electrode 131b may be exposed to a bottom surface of the body 110. In this case, the first electrode 131b may comprise regions having different thicknesses such that the bottom surface of the first electrode 131b protrudes. In other words, the region of the first electrode 131b having the protruding bottom surface may be thicker than that of another region of the first electrode 131b. Accordingly, such a structure can increase a heat dissipation area

In addition, the bottom surface of the first electrode 131b may make contact with the heat radiation pad 150.

Therefore, heat generated from the light emitting device 120 can be easily transferred to the support member 180 along the first electrode 131b and the heat radiation pad 150.

A lens may be provided on the light emitting device package according to the embodiment, and the lens may comprise a concave lens, a convex lens, a fresnel lens, or the selective combination of the concave and convex lenses. The light emitting device package may be integrated with the lens or may be separated from the lens, but the embodiment is not limited thereto.

A plurality of light emitting device packages according to the embodiment (embodiments) may be provided and used as a light source for an indication device (traffic light), a lighting device (a head light of a vehicle, a fluorescence lamp, or a street lamp), or a display apparatus (an electric sign board or an LCD panel). In addition, each embodiment is applicable to another embodiment.

The light emitting device package according to the embodiment is applicable to the light unit. The light unit comprises the array structure of a plurality of light emitting device packages.

FIG. 13 is an exploded perspective view showing a display apparatus 1000 according to the embodiment.

Referring to FIG. 13, the display device 1000 comprises a light guide plate 1041, a light emitting module 1031 for supplying the light to the light guide plate 1041, a reflective member 1022 provided below the light guide plate 1041, an optical sheet 1051 provided above the light guide plate 1041, a display panel 1061 provided above the optical sheet 1051, and a bottom cover 1011 for receiving the light guide plate 1041, the light emitting module 1031, and the reflective member 1022. However, the embodiment is not limited to the above structure.

The bottom cover 1011, the reflective sheet 1022, the light guide plate 1041 and the optical sheet 1051 may constitute a light unit 1050.

The light guide plate 1041 diffuses the light to provide surface light. The light guide plate 1041 may comprise transparent material. For instance, the light guide plate 1041 may comprise one of acryl-based resin, such as PMMA (polymethyl methacrylate), PET (polyethylene terephthalate), PC (polycarbonate), COC (cyclic olefin copolymer) and PEN (polyethylene naphthalate) resin.

The light emitting module 1031 supplies the light to at least one side of the light guide plate 1041. The light emitting module 1031 serves as the light source of the display apparatus 1000.

At least one light emitting module 1031 is provided to directly or indirectly supply the light from one side of the light guide plate 1041. The light emitting module 1031 may comprise a board 1033 and light emitting device packages 200 according to the embodiments. The light emitting device or the light emitting device packages 200 are arranged on the board 1033 while being spaced apart from each other at the predetermined interval. In other words, the light emitting devices may be arrayed on the board 1033 in the form of a chip or a package.

The board 1033 may comprise a printed circuit board (PCB) including a circuit pattern. In addition, the board 1033 may also comprise a metal core PCB (MCPCB) or a flexible PCB (FPCB) as well as the typical PCB, but the embodiment is not limited thereto. If the light emitting device packages 200 are installed on the side of the bottom cover 1011 or on a heat dissipation plate, the board 1033 may be omitted. The heat dissipation plate partially makes contact with the top surface of the bottom cover 1011.

In addition, the light emitting device packages 200 are arranged on the board 1033 such that light exit surfaces of the light emitting device packages 200 to output light are spaced apart from the light guide plate 1041 by a predetermined distance, but the embodiment is not limited thereto. The light emitting device packages 200 may directly or indirectly supply the light to a light incident part, which is one side of the light guide plate 1041, but the embodiment is not limited thereto.

The reflective member 1022 is disposed below the light guide plate 1041. The reflective member 1022 reflects upward the light which is incident through the bottom surface of the light guide plate 1041, thereby improving the brightness of the light unit 1050. For example, the reflective member 1022 may comprise PET, PC or PVC resin, but the embodiment is not limited thereto. The reflective member 1022 may serve as the top surface of the bottom cover 1011, but the embodiment is not limited thereto.

The bottom cover 1011 may receive the light guide plate 1041, the light emitting module 1031, and the reflective member 1022 therein. To this end, the bottom cover 1011 has a receiving section 1012 having a box shape with an opened top surface, but the embodiment is not limited thereto. The bottom cover 1011 can be coupled with the top cover, but the embodiment is not limited thereto.

The bottom cover 1011 may comprise metallic material or resin material. The bottom cover 1011 can be manufactured through a press process or an extrusion process. In addition, the bottom cover 1011 may comprise metal or non-metallic material having superior thermal conductivity, but the embodiment is not limited thereto.

The display panel 1061, for instance, is an LCD panel including first and second transparent boards, which are opposite to each other, and a liquid crystal layer interposed between the first and second boards. A polarizing plate may be attached to at least one surface of the display panel 1061, but the embodiment is not limited thereto. The display panel 1061 displays information by using light passing through the optical sheet 1051. The display device 1000 can be applied to various portable terminals, monitors or laptop computers, and televisions.

The optical sheet 1051 is disposed between the display panel 1061 and the light guide plate 1041 and comprises at least one transmittive sheet. For example, the optical sheet 1051 comprises at least one selected from the group consisting of a diffusion sheet, a horizontal and vertical prism sheet, and a brightness enhanced sheet. The diffusion sheet diffuses the incident light, the horizontal and vertical prism sheet concentrates the incident light onto a display region, and the brightness enhanced sheet improves the brightness by reusing the lost light. In addition, a protective sheet can be provided on the display panel 1061, but the embodiment is not limited thereto.

The light guide plate 1041 and the optical sheet 1051 can be provided in the light path of the light emitting module 1031 as optical members, but the embodiment is not limited thereto.

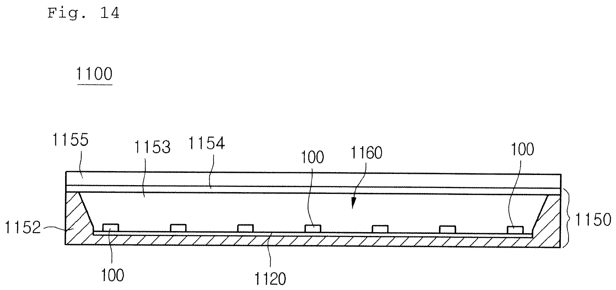

FIG. 14 is a sectional view showing a display apparatus according to the embodiment. A package of FIG. 14 comprises the structure in which light emitting devices are arrayed in the form of a chip or a package.

Referring to FIG. 16, the display device 1100 comprises a bottom cover 1152, a board 1120 on which the light emitting device packages 200 are arrayed, an optical member 1154, and a display panel 1155.

The board 1120 and the light emitting device packages 200 may constitute the light emitting module 1060. In addition, the bottom cover 1152, at least one light emitting module 1060, and the optical member 1154 may constitute the light unit. The light emitting device may be arrayed in the form of a chip or a package on the board 1129.

The bottom cover 1151 can be provided therein with a receiving section 1153, but the embodiment is not limited thereto.

The optical member 1154 may comprise at least one selected from the group consisting of a lens, a light guide plate, a diffusion sheet, a horizontal and vertical prism sheet, and a brightness enhanced sheet. The light guide plate may comprise PC or PMMA (Poly methyl methacrylate). The light guide plate can be omitted. The diffusion sheet diffuses the incident light, the horizontal and vertical prism sheet concentrates the incident light onto the display region, and the brightness enhanced sheet improves the brightness by reusing the lost light.

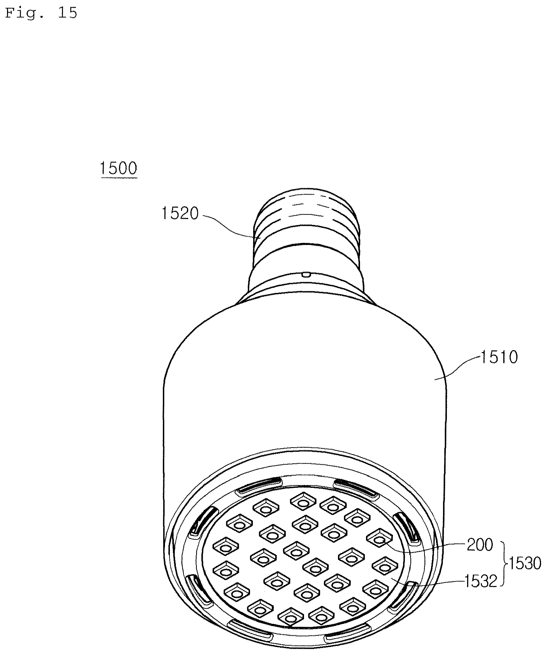

FIG. 15 is a perspective view showing a lighting system according to the embodiment.

Referring to FIG. 15, the lighting device 1500 comprises a case 1510, a light emitting module 1530 installed in the case 1510, and a connection terminal 1520 installed in the case 1510 to receive power from an external power source.

Preferably, the case 1510 comprises material having superior heat dissipation property. For instance, the case 1510 comprises metallic material or resin material.

The light emitting module 1530 may comprise a board 1532 and light emitting devices or light emitting device packages 200 installed on the board 1532. The light emitting device packages 200 are spaced apart from each other or arrayed in the form of a matrix. The light emitting devices may be arrayed on the board 1532 in the form of a chip or a package on the board 1532.

The board 1532 comprises an insulating member printed with a circuit pattern. For instance, the board 1532 comprises a PCB, an MCPCB, an FPCB, a ceramic PCB, and an FR-4 board.

In addition, the board 1532 may comprise material that effectively reflects the light. A coating layer can be formed on the surface of the board 1532. At this time, the coating layer has a white color or a silver color to effectively reflect the light.

At least one light emitting device package 200 is installed on the board 1532. Each light emitting device package 200 may comprise at least one LED (light emitting diode) chip. The LED chip may comprise an LED that emits the light of visible ray band having red, green, blue or white color and a UV (ultraviolet) LED that emits UV light.

The light emitting device packages 30 of the light emitting module 1530 can be variously combined to provide various colors and brightness. For instance, the white LED, the red LED and the green LED can be combined to achieve the high color rendering index (CRI).

The connection terminal 1520 is electrically connected to the light emitting module 1530 to supply power to the light emitting module 1530. The connection terminal 1520 has a shape of a socket screw-coupled with the external power source, but the embodiment is not limited thereto. For instance, the connection terminal 1520 can be prepared in the form of a pin inserted into the external power source or connected to the external power source through a wire.

Any reference in this specification to "one embodiment", "an embodiment", "example embodiment" etc., means that a particular feature, structure, or characteristic described in connection with the embodiment is comprised in at least one embodiment of the invention. The appearances of such phrases in various places in the specification are not necessarily all referring to the same embodiment. Further, when a particular feature, structure, or characteristic is described in connection with any embodiment, it is submitted that it is within the purview of one skilled in the art to effects such feature, structure, or characteristic in connection with other ones of the embodiments.

Although embodiments have been described with reference to a number of illustrative embodiments thereof, it should be understood that numerous other modifications and embodiments can be devised by those skilled in the art that will fall within the scope of the invention as defined by the appended claims. More particularly, various variations and modifications are possible in the component parts and/or arrangements of the subject combination arrangement within the scope of the disclosure, the drawings and the appended claims. In addition to variations and modifications in the component parts and/or arrangements, alternative uses will also be apparent to those skilled in the art.

## Claims

1. A light emitting apparatus comprising:
a support member (200);
a printed circuit board (300) having an opening and a circuit pattern on the support member; and
a light emitting diode device package (100) electrically connected with the printed circuit board and making contact with the support member through the opening,
wherein the light emitting diode device package comprises:
a package body (10) having a cavity (70); first (21) and second (22) frames each including a first part exposed in the cavity and a second part exposed to the outside of the package body;
a third frame (23) disposed on a bottom surface of the cavity and electrically and physically separated from the first and second frames;
a light emitting diode device (31) disposed on the third frame; and
wires (51,53) electrically connecting the first and second frames with the light emitting diode device,
wherein a bottom surface of the third frame is aligned in line with a bottom surface of the package body,
wherein a top surface of the third frame comprises a first plane having a first height, a second plane having a second height lower than the first height, the light emitting device is disposed on the second plane,
wherein a part of the package body is inserted in the opening of the printed circuit board,
wherein the bottom surface of the package body and the third frame contact with the support member through the opening of the printed circuit board,
wherein the second part of the first frame and the second part of the second frame contact with the circuit pattern of the printed circuit board,
wherein a thickness between the bottom surface of the package body and the first frame is the same as a thickness of the printed circuit board.

2. The light emitting apparatus of claim 1, wherein the third frame (23) includes a first connection part (23a) and a second connection part (23b) exposed at the lateral surface of the package body (10).

3. The light emitting apparatus of claim 1, wherein wherein the light emitting diode device includes a first light emitting diode (31) and a second light emitting diode (32), wherein a first electrode layer of the first light emitting diode is electrically connected with the first frame (21) by a first wire (51); a second electrode layer of the first light emitting diode (31) is electrically connected with a first electrode layer of the second light emitting diode by a second wire (52); a second electrode layer of the second light emitting diode is electrically connected with the second frame (22) by a third wire (53).

4. The light emitting apparatus of claim 3, wherein the light emitting diode device package (100) includes a zener diode (40) disposed on the third frame (23), wherein a first electrode of the zener diode is electrically connected with the first frame (21) by a fourth wire (54) and a second electrode of the zener diode is electrically connected with the second frame (22) by a fifth wire (55).

5. The light emitting apparatus of claim 1, further comprising an encapsulant layer (140) surrounding the light emitting diode device (120) and filled in the cavity.

6. The light emitting apparatus of claim 1, wherein the first plane of the third frame (23) is disposed lower than the first (21) and second (22) frames between the first and second frames.

7. The light emitting apparatus of claim 1, wherein the light emitting diode device package comprises a heat radiation pad (120) provided between bottom surfaces of the package body (10) and the support member.

8. The light emitting apparatus of claim 7, wherein the heat dissipation pad (150) comprises a thermally conductive tape or an UV tape.

9. The light emitting apparatus of claim 7, wherein the heat radiation pad (150) comprises at least one selected from the group consisting of metallic material, material containing carbon, and resin material.

10. A light emitting module comprising
a plurality of light emitting diode packages (1), a printed circuit (160) including a plurality of openings (155) disposed in line into which each of the light emitting diode device packages are inserted;
a support member (180) contacting with the plurality of light emitting diode device packages through the plurality of openings,
wherein each of the plurality of light emitting diode device packages (1) comprises:
a package body (10) having a cavity (70); first (21) and second (22) frames each including a first part exposed in the cavity and a second part exposed to the outside of the package body; a third frame (23) disposed on a bottom surface of the cavity and electrically and physically separated from the first and second frames; a light emitting diode (31) device disposed on the third frame; and wires (51,53) electrically connecting the first and second frames with the light emitting diode device,wherein a bottom surface of the third frame is aligned in line with a bottom surface of the package body, wherein a top surface of the third frame comprises a first plane having a first height, a second plane having a second height lower than the first height, the light emitting device is disposed on the second plane, wherein a part of the package body is inserted in the opening of the printed circuit board,wherein the bottom surface of the package body and the third frame contact with the support member through the opening of the printed circuit board,wherein the second part of the first frame and the second part of the second frame contact with the circuit pattern of the printed circuit board, and wherein a thickness between the bottom surface of the package body and the first frame is same as a thickness of the printed circuit board.

11. A lighting system comprising a light emitting apparatus or a light emitting module claimed according to one of claims 1 to 10.

## Patentansprüche

1. Lichtemittierende Vorrichtung aufweisend:
ein Trägerelement (200);
eine Leiterplatte (300) mit einer Öffnung und einem Leitungsmuster auf dem Trägerelement; und
eine lichtemittierende Diodenvorrichtungsbaugruppe (100), die elektrisch mit der Leiterplatte verbunden ist und durch die Öffnung mit dem Trägerelement in Kontakt ist,
wobei die lichtemittierende Diodenvorrichtungsbaugruppe (100) aufweist:
einen Baugruppenkörper (10) mit einer Ausnehmung (70);
einen ersten (21) und einen zweiten Rahmen (22), die jeweils einen ersten, in der Ausnehmung freiliegenden Teil und einen zweiten, zur Außenseite des Baugruppenkörpers freiliegenden Teil aufweisen;
einen dritten Rahmen (23), der an einer Bodenfläche der Ausnehmung angeordnet und elektrisch und physikalisch von dem ersten und dem zweiten Rahmen getrennt ist;
eine lichtemittierende Diodenvorrichtung (31), die am dritten Rahmen angeordnet ist; und
Drähte (51, 53), die den ersten und den zweiten Rahmen elektrisch mit der lichtemittierenden Diodenvorrichtung verbinden,
wobei eine Bodenfläche des dritten Rahmens mit einer Bodenfläche des Baugruppenkörpers in Reihe ausgerichtet ist,
wobei eine Oberseite des dritten Rahmens eine erste Ebene mit einer ersten Höhe und eine zweite Ebene mit einer zweiten Höhe aufweist, die niedriger als die erste Höhe ist, wobei die lichtemittierende Vorrichtung auf der zweiten Ebene angeordnet ist,
wobei ein Teil des Baugruppenkörpers in die Öffnung der Leiterplatte eingesetzt ist,
wobei die Bodenfläche des Baugruppenkörpers und der dritte Rahmen durch die Öffnung der Leiterplatte mit dem Trägerelement in Kontakt sind,
wobei der zweite Teil des ersten Rahmens und der zweite Teil des zweiten Rahmens mit dem Leitungsmuster der Leiterplatte in Kontakt sind,
wobei eine Dicke zwischen der Bodenfläche des Baugruppenkörpers und dem ersten Rahmen gleich einer Dicke der Leiterplatte ist.

2. Lichtemittierende Vorrichtung nach Anspruch 1, wobei der dritte Rahmen (23) ein erstes Verbindungsteil (23a) und ein zweites Verbindungsteil (23b) aufweist, die an der Seitenfläche des Baugruppenkörpers (10) freiliegen.

3. Lichtemittierende Vorrichtung nach Anspruch 1, wobei die lichtemittierende Diodenvorrichtung eine erste lichtemittierende Diode (31) und eine zweite lichtemittierende Diode (32) aufweist,
wobei eine erste Elektrodenschicht der ersten lichtemittierenden Diode durch einen ersten Draht (51) elektrisch mit dem ersten Rahmen (21) verbunden ist;
eine zweite Elektrodenschicht der ersten lichtemittierenden Diode (31) durch einen zweiten Draht (52) elektrisch mit einer ersten Elektrodenschicht der zweiten lichtemittierenden Diode verbunden ist;
eine zweite Elektrodenschicht der zweiten lichtemittierenden Diode durch einen dritten Draht (53) elektrisch mit dem zweiten Rahmen (22) verbunden ist.

4. Lichtemittierende Vorrichtung nach Anspruch 3, wobei die lichtemittierende Diodenvorrichtungsbaugruppe (100) eine Zenerdiode (40) aufweist, die auf dem dritten Rahmen (23) angeordnet ist,
wobei eine erste Elektrode der Zenerdiode durch einen vierten Draht (54) elektrisch mit dem ersten Rahmen (21) verbunden ist und eine zweite Elektrode der Zenerdiode durch einen fünften Draht (55) elektrisch mit dem zweiten Rahmen (22) verbunden ist.

5. Lichtemittierende Vorrichtung nach Anspruch 1, ferner aufweisend eine Verkapselungsschicht (140), die die lichtemittierende Diodenvorrichtung (120) umgibt und in die Ausnehmung gefüllt ist.

6. Lichtemittierende Vorrichtung nach Anspruch 1, wobei die erste Ebene des dritten Rahmens (23) weiter unten als der erste (21) und der zweite Rahmen (22) zwischen dem ersten und dem zweiten Rahmen angeordnet ist.

7. Lichtemittierende Vorrichtung nach Anspruch 1, wobei die lichtemittierende Diodenvorrichtungsbaugruppe ein Wärmeabstrahlungspad (120) aufweist, das zwischen der Bodenfläche des Baugruppenkörpers (10) und der des Trägerelements angeordnet ist.

8. Lichtemittierende Vorrichtung nach Anspruch 7, wobei das Wärmeabstrahlungspad (150) ein wärmeleitfähiges Band oder ein UV-Band aufweist.

9. Lichtemittierende Vorrichtung nach Anspruch 7, wobei das Wärmeabstrahlungspad (150) mindestens eines ausgewählt aus der Gruppe bestehend aus einem metallischen Material, einem Kohlenstoff enthaltenden Material und einem Harzmaterial aufweist.

10. Lichtemittierendes Modul aufweisend
mehrere lichtemittierende Diodenbaugruppen (1), eine Leiterplatte (160) mit mehreren, in Reihe angeordneten Öffnungen (155), in die jede der lichtemittierenden Diodenvorrichtungsbaugruppen eingesetzt sind;
ein Trägerelement (180), das durch die mehreren Öffnungen mit den mehreren lichtemittierenden Diodenvorrichtungsbaugruppen in Kontakt ist,
wobei jede der mehreren lichtemittierenden Diodenvorrichtungsbaugruppen (1) aufweist: einen Baugruppenkörper (10) mit einer Ausnehmung (70); einen ersten (21) und einen zweiten Rahmen (22), die jeweils einen ersten, in der Ausnehmung freiliegenden Teil und einen zweiten, zur Außenseite des Baugruppenkörpers freiliegenden Teil aufweisen; einen dritten Rahmen (23), der an einer Bodenfläche der Ausnehmung angeordnet und elektrisch und physikalisch von dem ersten und dem zweiten Rahmen getrennt ist; eine lichtemittierende Diode (31), die am dritten Rahmen angeordnet ist; und Drähte (51, 53), die den ersten und den zweiten Rahmen elektrisch mit der lichtemittierenden Diodenvorrichtung verbinden, wobei eine Bodenfläche des dritten Rahmens mit einer Bodenfläche des Baugruppenkörpers in Reihe ausgerichtet ist, wobei eine Oberseite des dritten Rahmens eine erste Ebene mit einer ersten Höhe und eine zweite Ebene mit einer zweiten Höhe aufweist, die niedriger als die erste Höhe ist, wobei die lichtemittierende Vorrichtung auf der zweiten Ebene angeordnet ist, wobei ein Teil des Baugruppenkörpers in die Öffnung der Leiterplatte eingesetzt ist, wobei die Bodenfläche des Baugruppenkörpers und der dritte Rahmen durch die Öffnung der Leiterplatte mit dem Trägerelement in Kontakt sind, wobei der zweite Teil des ersten Rahmens und der zweite Teil des zweiten Rahmens mit dem Leitungsmuster der Leiterplatte in Kontakt sind, und wobei eine Dicke zwischen der Bodenfläche des Baugruppenkörpers und dem ersten Rahmen gleich einer Dicke der Leiterplatte ist.

11. Beleuchtungssystem mit einer lichtemittierenden Vorrichtung oder einem lichtemittierenden Modul nach einem der Ansprüche 1 bis 10.

## Revendications

1. Appareil électroluminescent, comprenant :
un élément de support (200) ;
une carte de circuit imprimé (300) ayant une ouverture et un motif de circuit sur l'élément de support ; et
un boîtier de dispositif à diode électroluminescente (100) électriquement connecté à la carte de circuit imprimé et entrant en contact avec l'élément de support par l'intermédiaire de l'ouverture,
dans lequel le boîtier de dispositif à diode électroluminescente comprend :
un corps de boîtier (10) ayant une cavité (70) ;
des premier (21) et second (22) cadres incluant chacun une première partie exposée dans la cavité et une seconde partie exposée à l'extérieur du corps de boîtier ;
un troisième cadre (23) disposé sur une surface inférieure de la cavité et électriquement et physiquement séparé des premier et deuxième cadres ;
un dispositif à diode électroluminescente (31) disposé sur le troisième cadre ; et
des fils (51, 53) connectant électriquement les premier et deuxième cadres au dispositif à diode électroluminescente,
dans lequel une surface inférieure du troisième cadre est alignée en ligne avec une surface inférieure du corps de boîtier,
dans lequel une surface supérieure du troisième cadre comprend un premier plan ayant une première hauteur, un deuxième plan ayant une seconde hauteur plus basse que la première hauteur, le dispositif électroluminescent est disposé sur le deuxième plan,
dans lequel une partie du corps de boîtier est insérée dans l'ouverture de la carte de circuit imprimé,
dans lequel la surface inférieure du corps de boîtier et le troisième cadre entrent en contact avec l'élément de support par l'intermédiaire de l'ouverture de la carte de circuit imprimé,
dans lequel la seconde partie du premier cadre et la seconde partie du deuxième cadre entrent en contact avec le motif de circuit de la carte de circuit imprimé,
dans lequel une épaisseur entre la surface inférieure du corps de boîtier et le premier cadre est la même qu'une épaisseur de la carte de circuit imprimé.

2. Appareil électroluminescent selon la revendication 1, dans lequel le troisième cadre (23) inclut une première partie de connexion (23a) et une seconde partie de connexion (23b) exposées au niveau de la surface latérale du corps de boîtier (10).

3. Appareil électroluminescent selon la revendication 1, dans lequel le dispositif à diode électroluminescente inclut une première diode électroluminescente (31) et une seconde diode électroluminescente (32),
dans lequel une première couche d'électrode de la première diode électroluminescente est électriquement connectée au premier cadre (21) par un premier fil (51) ;
une seconde couche d'électrode de la première diode électroluminescente (31) est électriquement connectée à une première couche d'électrode de la seconde diode électroluminescente par un deuxième fil (52) ;
une seconde couche d'électrode de la seconde diode électroluminescente est électriquement connectée au deuxième cadre (22) par un troisième fil (53).

4. Appareil électroluminescent selon la revendication 3, dans lequel le boîtier de dispositif à diode électroluminescente (100) inclut une diode Zener (40) disposée sur le troisième cadre (23),
dans lequel une première électrode de la diode Zener est électriquement connectée au premier cadre (21) par un quatrième fil (54) et une seconde électrode de la diode Zener est électriquement connectée au deuxième cadre (22) par un cinquième fil (55).

5. Appareil électroluminescent selon la revendication 1, comprenant en outre une couche d'encapsulation (140) entourant le dispositif à diode électroluminescente (120) et remplissant la cavité.

6. Appareil électroluminescent selon la revendication 1, dans lequel le premier plan du troisième cadre (23) est disposé plus bas que les premier (21) et second (22) cadres entre les premier et deuxième cadres.

7. Appareil électroluminescent selon la revendication 1, dans lequel le boîtier de dispositif à diode électroluminescente comprend une plage à rayonnement de chaleur (120) prévue entre des surfaces inférieures du corps de boîtier (10) et de l'élément de support.

8. Appareil électroluminescent selon la revendication 7, dans lequel la plage (150) à dissipation de chaleur comprend une bande thermiquement conductrice ou une bande UV.

9. Appareil électroluminescent selon la revendication 7, dans lequel la plage (150) à rayonnement de chaleur comprend au moins un sélectionné parmi le groupe constitué de : matériau métallique, matériaux contenant du carbone, et matériau en résine.

10. Module électroluminescent, comprenant
une pluralité de boîtiers (1) de diode électroluminescente, un circuit imprimé (160) incluant une pluralité d'ouvertures (155) disposées en ligne, dans lesquelles chacun des boîtiers de dispositif à diode électroluminescente sont insérés ;
un élément de support (180) entrant en contact avec la pluralité de boîtiers de dispositif à diode électroluminescente par l'intermédiaire de la pluralité d'ouvertures, dans lequel chacun de la pluralité de boîtiers (1) de dispositif à diode électroluminescente comprend :
un corps de boîtier (10) ayant une cavité (70) ; des premier (21) et deuxième (22) cadres, chacun incluant une première partie exposée dans la cavité et une seconde partie exposée à l'extérieur du corps de boîtier ; un troisième cadre (23) disposé sur une surface inférieure de la cavité et électriquement et physiquement séparé des premier et deuxième cadres ; un dispositif à diode électroluminescente (31) disposé sur le troisième cadre ; et des fils (51, 53) connectant électriquement les premier et deuxième cadres au dispositif à diode électroluminescente, dans lequel une surface inférieure du troisième cadre est alignée en ligne avec une surface inférieure du corps de boîtier, dans lequel une surface supérieure du troisième cadre comprend un premier plan ayant une première hauteur, un deuxième plan ayant une seconde hauteur inférieure à la première hauteur, le dispositif électroluminescent est disposé sur le deuxième plan, dans lequel une partie du corps de boîtier est insérée dans l'ouverture de la carte de circuit imprimé, dans lequel la surface inférieure du corps de boîtier et le troisième cadre entrent en contact avec l'élément de support par l'intermédiaire de l'ouverture de la carte de circuit imprimé, dans lequel la seconde partie du premier cadre et la seconde partie du deuxième cadre entrent en contact avec le motif de circuit de la carte de circuit imprimé, et dans lequel une épaisseur entre la surface inférieure du corps de boîtier et le premier cadre est la même qu'une épaisseur de la carte de circuit imprimé.

11. Système d'éclairage, comprenant un appareil électroluminescent ou un module électroluminescent selon une des revendications 1 à 10.
